# EUROPEAN PATENT SPECIFICATION

(11) **EP 4 423 202 B1**
(45) Date of publication and mention of the grant of the patent: **22.10.2025**
(21) Application number: 22709013.1
(22) Date of filing: 21.01.2022
(51) Int. Cl.: C09D 11/037, C09D 11/101, C09D 11/102, C09D 11/52, G01K 7/00

(54) **PRINTABLE INK FORMULATION BASED ON NICR AND NIAL ALLOYS AND METHOD FOR PRODUCING THE PRINTABLE INK FORMULATION**
DRUCKBARE TINTENFORMULIERUNG AUF BASIS VON NICR UND NIAL-LEGIERUNGEN UND VERFAHREN ZUR HERSTELLUNG DER DRUCKBAREN TINTENFORMULIERUNG
FORMULATION D'ENCRE IMPRIMABLE À BASE D'ALLIAGES DE NICR ET DE NIAL ET PROCÉDÉ DE PRODUCTION DE LA FORMULATION D'ENCRE IMPRIMABLE

(30) Priority: 30.12.2021 PT 2021117722
(43) Date of publication of application: 04.09.2024
(73) Proprietor: Bosch Car Multimedia Portugal, S.A., 4705-820 Braga (PT); Universidade do Minho, 4700-320 Braga (PT)
(72) Inventor: PINTO DA COSTA, Pedro Miguel, 4705-820 Braga (PT); CARVALHO CEREJEIRA FONTES DELGADO, Isabel A., 4705-820 Braga (PT); DE BARROS ALVES, José Ricardo, 4705-820 Braga (PT); MACHADO VIANA, Júlio César, 4800-058 Guimarães (PT); ZLATEV DÉNCHEV, Zlatan, 4800-060 Guimarães (PT); CÂNDIDO HOMEM, Natália, 4800-060 Guimarães (PT); CANO RAYA, Clara Maria, 4800-060 Guimarães (PT); PEREIRA AFONSO, Cátia Juliana, 4800-060 Guimarães (PT)
(74) Representative: Couto, Cláudia
(86) International application number: PCT/IB2022/050514
(87) International publication number: WO 2023/126686

(56) References cited:
- WO-A1-2011/116303
- WO-A1-2020/016636
- WO-A1-92/17774
- CN-A- 110 387 165
- US-A1- 2005 257 822

## Description

### Technical field

This invention relates to printable ink formulations based on NiCr and NiAl alloys, a method for producing said ink formulations, a thermocouple sensor made from the printable ink formulation and a method for producing said thermocouple sensor.

### Background art

Document WO2020016636 describes a thermal sensor for monitoring PCB soldering temperature and respective PCB, manufacturing and monitoring method thereof.

Document US20110277803 describes a thermocouple device comprising a flexible non-planar substrate, a first printed thermocouple element comprising a first metal containing ink composition applied to the flexible non-planar substrate, and a second printed thermocouple element in electrical contact with the first printed thermocouple element making a thermocouple junction.

Document US9798279 B2 describes a fuser heater within a printing device that includes a substrate with conductive traces and a resistive trace having a first end and a second end.

Document US8617427 B2 describes an electrically conductive polymeric compositions, contacts, assemblies and methods. Additionally, CN 110 387 165 might be cited.

### Summary

The drawbacks of the previously disclosed thermally curable conductive compositions for screen printing designated for use in electronics are overcome in the present invention. Herein, Alumel- and Chromel-filled monomer/oligomer formulations, radically polymerizable at less than 260°C are prepared and tested for electrical conductivity and thermoelectric response. Moreover, a method for producing said inks is also disclosed, involving the use of commercially available ingredients and being relatively simple for execution for those sufficiently skilled in the art. These compositions are especially designated for screen printing of thermocouple sensors on various substrates, including glass, PCB and other organic or inorganic substrates. This was demonstrated by printing of thermocouple sensors using the Alumel- and Chromel-filled monomer/oligomer ink formulations initially activated for radical polymerization, followed by a curing cycle in the 90-250°C range and subsequent testing their electrical conductivity and their voltage output as a function of temperature.

### General description

This invention relates to printable ink formulations based on Ni-Cr (preferably Chromel) and Ni-Al (preferably Alumel) alloys and a method for producing these printable ink formulations. These inks are suitable for printing of K-type thermocouple sensors on printed circuit boards, or other type of sensors based on those materials, and other type of applications. More particularly, the present invention provides thermally curable inks comprising Chromel and Alumel particulate alloys dispersed in a polymer binder representing a mixture of chemically modified acrylate monomers with various functionalities, appropriately initiated for thermal cure. These inks can be screen-printed on various substrates and then thermally cured at temperatures below 260°C. In all embodiments, the printable inks are free of volatile solvents.

Electrically conductive polymer-metal compositions are well known and have a wide variety of applications. These compositions can be used to form electrically conductive and printable thin films and/or patterns in electronic devices, for example for screen printed K-type thermocouple sensors over printed circuit boards (PCB). For these applications, it would be desirable to provide polymer-metal compositions that can be printable, then curable at temperatures not higher than 250°C so as not to damage the adjacent electronic elements and the PCB, providing at the same time the electrical conductivity that is appropriate for thermocouple sensor to operate correctly. To decrease the production costs and eliminate environmental concerns, it would be particularly desirable to provide solvent-free polymer-metal conductive compositions.

At this moment there are no inventions on specially designed inks for screen printed K-type thermocouple sensors. Various single-metal containing inks (Au, Ag, Ni, or Cu) exist as commercial and/or experimental products that were tried for sensor development, e.g., combining Ag- and Ni-containing inks.

The existing inks whose composition is disclosed in the available patent documents and the other known conductive polymer-metal compositions until now are not specially developed for printing of K-type thermocouple sensors. They contain high percentage (more than 60 wt.%) of very expensive Au and/or Ag particles. There are only few companies that commercialize such products. There are currently no ink formulations for printing K-type thermocouples, based on Ni-Al and Ni-Cr alloys (trade names Alumel and Chromel, respectively).

The invention also provides methods of stabilization of the printable inks against oxidation that provides their necessary electrical conductivity. The invention also includes a method for preparation and screen printing of Chromel-Alumel thermocouples applied on various substrates suitable for temperature control up to 250°C.

### Brief description of the drawings

For easier understanding of this application, figures are attached in the annex that represent the preferred forms of implementation which nevertheless are not intended to limit the technique disclosed herein.
**Figure 1** represents an Alumel/Chromel thermocouple assembly printed on glass prepared for electircal characterization.
**Figure 2** represents an Alumel/Chromel thermocouple assembly printed on PCB substrate.
**Figure 3** is a graph representing the Seebeeck coefficient determination and its comparison for Alumel- and Chromel thermocouple sensors printed on glass and normal Chromel/Alumel wire thermocouple in the temperature range of 50-250°C.

### Description of embodiments

Now, preferred embodiments of the present application will be described in detail with reference to the annexed drawings. However, they are not intended to limit the scope of this application.

The preferred embodiment of the Chromel- and Alumel containing compositions of this invention is as conducting inks for screen printing of thermocouple devices with good adhesion to glass and PCB substrates, with well-predictable voltage output in the temperature range of 50-250°C, these inks being at the same time curable at temperatures lower than 260°C.

The printable ink formulation, comprises the following composition:
i) Chromel alloy or Alumel alloy micro-nanoparticles;
ii) a mixture of fatty acid modified epoxidized acrylate and/or methacrylate monomers or oligomers with aliphatic di- or triacrylate monomers and/or oligomers;
iii) one or more polymerizable diluents;
iv) one or more free radical initiators.

Optionally, the printable ink formulation further comprises conductive inorganic or organic particulate materials. The conductive inorganic or organic particulate materials are present in a concentration between 1-10% wt. by total weight of the ink formulation.

Optionally, the printable ink formulation further comprises conductive polymers. The conductive polymers are present in a concentration between 1-10% wt. by total weight of the ink formulation.

A number of other conductive organic or inorganic particulate materials can be added or otherwise incorporated in the polymer-Chromel or polymer-Alumel formulation.

Some preferable but non-limiting examples are carbon allotrope fillers such as carbon nanotubes, carbon nanofibers and/or particles of carbon black commercially available from numerous manufacturers.

Optionally, the ink formulations may comprise also conductive polymers as polyaniline (PANI), poly(3-hexylthiophene-2,5-diyl) (P3HT), poly (3,4-ethylenedioxythiophene) (PEDOT) or other inherently conductive polymer particles with preferred sizes between 0,1-100 micrometers.

For both alloys, micro-nanoparticles with sizes between 0.2-12 µm are used. The composition of the micro-nanoparticles corresponds to that of Alumel (92-95% Ni, 2.0% Al, 2.0% Mn, 1-3% Si), and Chromel (approximately 90% Ni, 10% Cr) commercial alloys.

The percentage of the Chromel alloy or Alumel alloy in the uncured ink formulation varies in the range of 55-95% by weight in relation to the total ink formulation weight.

The Chromel alloy or Alumel alloy micro-nanoparticles can be spherical or have other shapes.

The term "oligomer" as used herein generally refers to a polymer or corresponding structure having a number average molecular weight of from about 250 to about 20,000, and preferably from about 500 to about less than 10,000 Daltons.

The term "epoxy acrylate or methacrylate monomer/oligomer" as used herein refers to monomers or oligomers formed by reacting an epoxy group containing reagent with one or more molecules with acrylate or methacrylate moieties.

The formulation of the present invention with preferred embodiment as printable inks for thermocouple sensors comprise preferably epoxy acrylate and/or methacrylate oligomers, which include one or more fatty acid moieties. The fatty acid modified epoxy acrylate oligomers are typically formed by reacting an epoxy resin with a mixture of acrylates and/or methacrylates (or acrylic acid and/or methacrylic acid), and one or more fatty acids. Most preferably, the epoxy acrylate or methacrylate oligomers are fatty acid modified acrylate or methacrylate epoxy oligomers having a functionality from 2 to 6. The fatty acid modified epoxy acrylates and/or methacrylates can be in the form of monomers, selectively polymerized to form oligomers, or combinations of monomers and oligomers.

A non-limiting example of commercial fatty acid modified diacrylate epoxy oligomer is the product Genomer 2312 from Rahn USA, believed to represent epoxidized soy oil acrylate with functionality of 3-4, and viscosity at 25°C of 20000 mPa-s. Other compounds of the same group such as Genomer 2259 (average functionality of 2, viscosity at 25°C 25000 mPa-s) or Genomer 3611 (average functionality of 6, viscosity at 25°C 8000 mPa-s) can also be applied optionally.

Additional examples of commercially available oligomers suitable for applications in printable ink formulations include, but are not limited to, preferably CN132 (aliphatic diacrylate oligomer, functionality of 2, viscosity at 25°C 1000 mPa-s) and, optionally CN133 (aliphatic triacrylate oligomer, functionality of 3, viscosity at 25°C 18000 mPa-s), both available from Arkema under the trade name Sartomer.

The effective amount of the fatty acid-modified acrylate epoxy monomer/oligomer is 1.0-8.0 wt.% by total weight of the ink formulation.

The aliphatic di- or triacrylate monomers or oligomers, or their mixture, are present between 2.0-25.0 wt.% by total weight of the ink formulation.

The term "effective amount" as used herein generally refers to the weight percentage in the final uncured ink formulation that, after its curing, provides the highest electrical conductivity.

The printable formulations of this invention comprise also effective amounts of one or more polymerizable diluents selected from 1,2-ethanediol diacrylate, 1,2-ethanediol dimethacrylate, 1,2-propanediol diacrylate, 1,3-propanediol diacrylate and the respective dimethacrylates, 1,6-hexanediol diacrylate (HDDA) or 1,6-hexanediol dimetthacrylate.

An example of its effective amount is a concentration from about 1.0% to about 8.0% wt. by total weight of the ink formulation.

In certain cases, especially whenever carbon allotropes or conductive organic or inorganic particulate materials are additionally used to improve or preserve the conductivity of the cured thermocouple sensors, it may be necessary to increase the HDDA concentration up to 8.0% wt. by total the ink formulation.

The inventive formulations also comprise one or more free radical initiators, preferably bis(1-methyl-1-phenylethyl) peroxide. Other free radical initiators, such as dicumyl peroxide, dibenzoyl peroxide, 1,1-di(tert-amylperoxy)cyclohexane, 2,2'-Azobis(2-methylpropionit-rile) (AIBN). Similar agents or combinations thereof may be optionally used. It is contemplated that nearly any organic peroxide selected to be compatible with the components of the ink formulation and their curing conditions can be used.

The selected free radical initiator(s) is used at a concentration generally effective to initiate radical polymerization of the polymerizable constituents of the printable ink formulation. Such concentrations are typically from between 0.02%-1.0% by total weight of the ink formulation.

The method for producing the printable ink formulation of the present invention comprises the following steps:
- Mixing a free radical initiator with a polymerizable diluent, followed by the addition of a mixture of fatty acid modified epoxy acrylate and/or methacrylate monomers or oligomers;
- The previous mixture is homogenized by mixing at a temperature between 20 to 30°C to produce a binder component;
- Adding the Alumel alloy or Chromel alloy micro-nanoparticles to the binder component, followed by additional homogenization by mixing, to produce an uncured ink formulation containing the Ni-alloy.

In the preferred embodiments conductive organic or inorganic particulate materials are added to the Chromel alloy or Alumel alloy before their admixture to the binder component.

In the preferred embodiments the Alumel alloy or Chromel alloy micro-nanoparticles are used as a powder.

In the preferred embodiments the concentration of the polymerizable diluent varies in a concentration between 1.0-8.0% wt. by total weight of the ink formulation. The polymerizable diluent is selected from 1,2-ethanediol diacrylate, 1,2-ethanediol dimethacrylate, 1,2-propanediol diacrylate, 1,3-propanediol diacrylate and the respective dimethacrylates, 1,6-hexanediol diacrylate or 1,6-hexanediol dimetthacrylate.

In the preferred embodiments the free radical initiator is selected from, but not limited to, an organic peroxide, dicumyl peroxide, bis(1-methyl-1-phenylethyl) peroxide, dibenzoyl peroxide, dibenozoyl peroxide, 1,1-di(*tert-*amylperoxy)cyclohexane, 2,2'-Azobis(2-methylpropionitrile). The preferred concentrations of the free radical initiator vary in a concentration between 0.02-1.0% wt. by total weight of the ink formulation.

In some of the preferred embodiments, the fatty acid-modified acrylate epoxy monomer/oligomer is selected from, but not limited to, the group of Genomer 2312, Genomer 2259, or Genomer 3611. The preferred concentration of the Genomer component (single product or mixture of several) varies in a concentration between 1.0-8.0% of the total weight of the ink formulation.

In some of the preferred embodiments, the aliphatic di- or triacrylate oligomer is selected from, but not limited to, the group of Sartomer CN133 or Sartomer CN132, or their mixture. The preferred concentration varies in a concentration between 2.0-25.0% wt. by total weight of the ink formulation.

In some of the preferred embodiments, prior to being admixed to the binder component, the Chromel alloy micro-nanoparticles are treated with 1-5 M HCl for 10 to 120 minutes, preferably 10 to 60 minutes,1h at 20-50°C in order to remove Ni and Cr oxides formed during the gas atomization of the respective alloy.

In some of the preferred embodiments, to the uncured Chromel-containing ink formulations certain carbon allotropes are added, being from the group of, but not limited to, carbon nanotubes, carbon nanofibers or carbon black, with the objective to fine-tune the electrical conductivity of this ink after curing. These carbon allotropes and/or conductive organic or inorganic particulate materials are added if no HCL treatment is applied in order to obtain a thermocouple sensor with sufficient electrical conductivity.

Optionally, instead of the carbon allotrope or in addition to it, conductive polymer powders from the group of, but not limited to PANI, P3HT or PEDOT can be added.

The preferred combined concentrations of the carbon allotrope and the conductive organic or inorganic polymer particulate material varies in a concentration between 1-10% wt. by the weight of the ink formulation.

The uncured ink formulations containing Chromel or Alumel alloys, once prepared, can be printed on glass, PCB or other substrate by a printing technology such as Dr. Blade, screen printing, pad printing, or similar techniques, to produce various printed patterns, preferably strips, lines or more complex patterns, whereby the Alumel-containing strips are put in electrical contact with Chrome-containing strips forming the "hot junction" of a K-type thermocouple sensor.

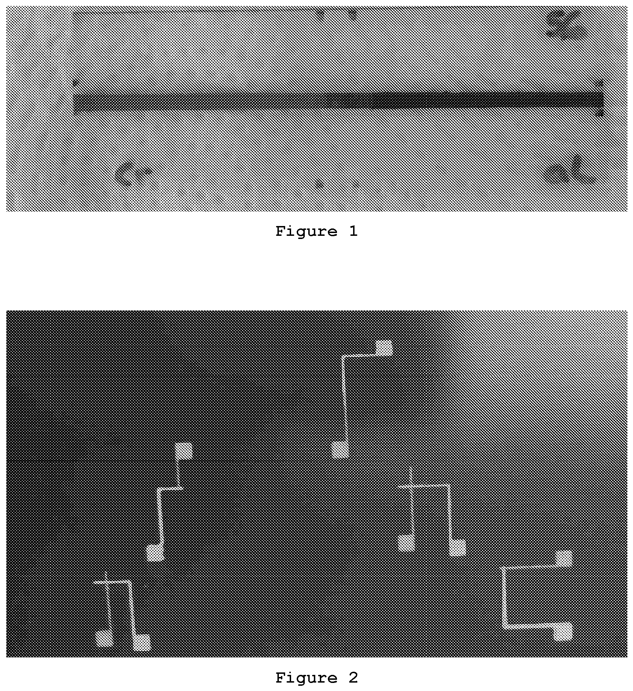

Figure 1 depicts an example of thermocouple sensor with Alumel- and Chromel-containing ink strips with dimensions: width 2 mm, length 40 mm, thickness 0,05 mm, and hot junction overlapping zone of 10 mm² printed by the Dr. Blade method on glass substrate.

Figure 2 depicts another possible example of thermocouple sensor device comprising a Chromel-ink section and an Alumel-ink section screen printed on a PCB, each section with a minimum width of 1 mm, with a zone of hot junction of 1 mm².

It is contemplated that many different printed thermocouple designs are possible for the hot junction. This hot junction may be printed over a dielectric layer and can be further protected by high thermal conductive coating.

Several printing techniques involving an ink formulation can be used, for example, screen printing, pad printing, inkjet printing, but not limited to these techniques.

Several substrates can be used (e.g., polymeric, ceramic, metallic, cork, wood).

After printing the thermocouple sensor, the inks formulation is cured by thermal treatment, gradually increasing the temperature in the range between 50-250°C, more preferably in the 90-200°C range, in the atmosphere of air. Optionally, vacuum or inert atmosphere can be applied for curing. Preferably, the curing is performed in an oven with temperature control and optional possibilities for evacuation or application of inert atmosphere. The preferred time durations of the curing vary in the range between 20-180 min.

After completion of the curing, the printed thermocouple sensor was tested for electrical conductivity in the Chromel and Alumel ink zones, as well as in the zone of their overlapping.

The thermocouple sensor may be optionally subjected to chemical treatment, preferably by etching with acids, or to physical treatments, preferably mechanical abrasion or laser ablation in order to fine-tune the electrical conductivity and/or the voltage response at different temperatures of the printed thermocouple device.

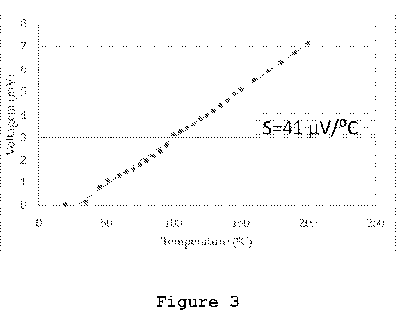

Figure 3 depicts the voltage dependence as a function of temperature in the 30-260°C of cured thermocouple devices produced with the developed inks. The response is strictly linear, with Seebeeck coefficients of 41 µV/°C. and almost coincides with that of conventional thermocouple of the same type. This proves the feasibility of the ink formulations and the printed thermocouple sensors thereof disclosed in the present invention.

### Examples

### Example 1.

Compositions of Examples 1-4 displayed in Table 1 exemplify the components and their weight percentages in the binder component of the ink formulations of the present disclosure. Example 1 is a reference using a low boiling point solvent, examples 2-4 are solvent-less preferred embodiment formulations for the binder of the printable inks for thermocouple sensors.

**Table 1.**

| Control and preferred embodiment of binder components, wt. % | | | | |
|---|---|---|---|---|
| Binder components | Example 1 | Example 2 (M2) | Example 3 (M3) | Example 4 (M4) |
| HDDA | 22.0 | 33.5 | 24.0 | 33.5 |
| Genomer 2312 | - | - | - | 15.0 |
| Genomer 2259 | 10.0 | 15.0 | - | - |
| Genomer 3611 | - | - | 23.0 | - |
| Sartomer CN132 | - | - | - | 50.0 |
| Sartomer CN133 | 33.0 | 50.0 | 53.0 | - |
| Dicumyl peroxide | 0.6 | 1.5 | 1.0 | 1.5 |
| Butyl carbitol^{a)} | 34.4 | - | - | - |

| | | | | |
|---|---|---|---|---|
| ^{a)} Low boiling point organic solvent (control sample) | | | | |

The binder components of Examples 1-4 were screen printed on glass- and PCB substrates and tested for polymerizability at temperatures in the 90-250°C range. All of them polymerized at said conditions but only binder components of the Examples 2-4, i.e., M2, M3 and M4, formed smooth thin films. The binder component of Example 1 formed a foam-like polymerizate unsuitable for the preferred embodiment as printable inks.

### Example 2.

Binder component M2, M3 and M4 were mixed with Chromel or Alumel micro-nanoparticles as described above to obtain uncured ink formulations for screen printing in the form of viscous pastes. In 100 weight parts of the respective uncured ink formulation, 90 parts were of the respective Ni-Cr or Ni-Al alloy and 10 parts of the respective binder component. Three pastes containing Alumel and other three containing Chromel were printed on glass substrates with Dr. Blade technology to prepare overlapping rectangular stripes of three thermocouple sensors as indicated in Figure 1. The said three sensors were cured in the interval 90-250°C for 20-180 min. The resistivity results presented in Table 2 were obtained right after the curing of the ink formulations and their post-treatment in all zones with 2M HCl for 20 min.

**Table 2.**

| | Electrical resistivity in the different zones thermocouple, Ohms [Q] | | |
|---|---|---|---|
| Binder component | Chromel zone | Alumel zone | Superposition zone |
| M2 | 2100.0 | 150,8 | 1210.2 |
| M3 | 1200.5 | 88.7 | 887.0 |
| M4 | 53.6 | 54.7 | 56.6 |

### Example 3.

This example illustrates the tentative to avoid the use of strong acid to treat the cured thermocouple applying this treatment to the initial metal alloy powders. Thus, the binder component M4 was used to produce Chromel and Alumel inks according to Example 2. Before being introduced to the binder component, the Chromel and Alumel micro-nanoparticle powders were differently treated with HCl acid and/or additionally compounded with carbon nanofibers and conducting polymer (PEDOT). The Alumel and Chromel ink formulations so produced were employed in the screen printing of thermocouple sensors according to Figures 1 and 2, that were then cured by heating in the range of 90-250°C for a time between 20-180 min. The resistivity was measured in the Chromel, Alumel and overlapping zones and is shown in Table 3.

**Table 3.**

| Metal alloys | Treatment and conditions | Electrical resistivity in the different zones thermocouple, Ohms [Ω] | | |
|---|---|---|---|---|
| | | Chromel zone | Alumel zone | Superposition zone |
| Chromel/Alumel | No acidic post- or pre-treatment | - | - | - |
| Chromel/Alumel | Pre-treatment with 2M HCl for Chromel and 4M HCl for Alumel/1h | 25000 | 53.0 | 9000.0 |
| Chromel+CNF/ Alumel | Addition of 10% CNF in Chromel and pre-treatment of Alumel with 4M HCl/ 1h | 180.0 | 670.0 | 1500.0 |
| Chromel + PEDOT+CNF/ Alumel + PEDOT+ CNF | Addition to both particles of 5% of CNF + 0.5 % PEDOT | 200.0 | 350.0 | 520.5 |

## Claims

1. A printable ink formulation based on NiCr and NiAl alloys comprising the following composition:
i) Chromel alloy or Alumel alloy micro-nanoparticles with sizes between 0.2-12 µm and present in an amount between 55-95% wt. by total weight of the formulation;
ii) a mixture of fatty acid modified epoxidized acrylate and/or methacrylate monomers or oligomers with aliphatic di- or triacrylate monomers and/or oligomers;
iii) one or more polymerizable diluents;
iv) one or more free radical initiators.

2. Printable ink formulation according to claim 1, wherein the formulation further comprises conductive organic or inorganic particulate materials selected from carbon allotrope fillers such as carbon nanotubes, carbon nanofibers and/or particles of carbon black, and present in a concentration between 1-10% wt. by total weight of the ink formulation.

3. Printable ink formulation according to any of the previous claims, wherein the formulation further comprises conductive polymers selected from polyaniline, poly(3-hexylthiophene-2,5-diyl), poly (3,4-ethylenedioxythiophene) or other inherently conductive polymer particles with preferred sizes between 0,1-100 micrometers µm, and present in a concentration between 1-10% wt. by total weight of the ink formulation.

4. Printable ink formulation according to any of the previous claims, wherein the fatty acid-modified acrylate epoxy monomer/oligomer are selected among Genomer 2312, Genomer 2259, Genomer 3611 being present in a concentration between 1.0-8.0% wt. by total weight of the ink formulation.

5. Printable ink formulation according to any of the previous claims, wherein the aliphatic diacrylate or triacrylate monomers or oligomers are selected from Sartomer CN132, Sartomer CN133, or their mixture, and are present in a concentration between 2.0-25.0% wt. by total weight of the formulation.

6. Printable ink formulation according to any of the previous claims, wherein the polymerizable diluent is selected from 1,2-ethanediol diacrylate, 1,2-ethanediol dimethacrylate, 1,2-propanediol diacrylate, 1,3-propanediol diacrylate and the respective dimethacrylates, 1,6-hexanediol diacrylate or 1,6-hexanediol dimetthacrylate, and is present in a concentration range from 1.0-8.0% wt. by total weight of the ink formulation.

7. Printable ink formulation according to any of the previous claims, wherein one or more free radical initiators are present in a concentration between 0.02-1.0% by total weight of the formulation.

8. Printable ink formulation according to any of the previous claims, wherein one or more free radical initiators is selected from an organic peroxide, dicumyl peroxide, bis(1-methyl-1-phenylethyl) peroxide, dibenzoyl peroxide, dibenozoyl peroxide, 1,1-di(tert-amylperoxy)cyclohexane, 2,2'-Azobis(2-methylpropionit-rile).

9. Method for producing the printable ink formulation described in any of the previous claims, comprising the following steps:
- Mixing a free radical initiator with a polymerizable diluent, followed by the addition of a mixture of fatty acid modified epoxy acrylate and/or methacrylate monomers or oligomers;
- The previous mixture is homogenized by mixing at a temperature between 20 to 30°C to produce a binder component;
- Adding the Alumel alloy or Chromel alloy micro-nanoparticles to the binder component, followed by additional homogenization by mixing, to produce an uncured ink formulation containing the Ni-alloy.

10. Method according to the previous claim, wherein conductive organic or inorganic particulate materials are further added to the Chromel alloy or Alumel alloy before their admixture to the binder component.

11. Method according to any of the claims 9 to 10, wherein the Chromel alloy micro-nanoparticles are treated with 1-5 M HCl for 10 to 120 minutes at 20-50°C before being added to the binder component.

12. A thermocouple sensor comprising the printable ink formulation described in any of the claims 1 to 8.

13. The thermocouple sensor according to the previous claim that is of the K-type.

14. Method of producing a thermocouple sensor described in claims 12 to 13, comprising the following steps:
- Printing a thermocouple sensor on a subtract using the printable ink formulation described in any of the claims 1 to 8;
- Curing the printable ink formulation by gradually increasing the temperature in the range between 50-250°C, between 20-180 min.

15. Method of producing a thermocouple sensor according to the previous claim, wherein the method further comprises a step of chemical treatment or physical treatment to the cured thermocouple sensor.

16. A printed circuit board comprising at least one thermocouple sensor as described in any of the claims 12 to 13.

## Patentansprüche

1. Eine druckbare Tintenformulierung auf Basis von NiCr- und NiAl-Legierungen mit der folgenden Zusammensetzung:
i) Mikronanopartikel aus Chromel-Legierung oder Alumel-Legierung mit Größen zwischen 0,2-12 µm und vorliegend in einer Menge zwischen 55-95 Gew.-% des Gesamtgewichts der Formulierung;
ii) eine Mischung aus fettsäuremodifizierten epoxidierten Acrylat- und/oder Methacrylatmonomeren oder -oligomeren mit aliphatischen Di- oder Triacrylatmonomeren und/oder - oligomeren;
iii) ein oder mehrere polymerisierbare Verdünnungsmittel;
iv) einen oder mehrere Radikalinitiatoren.

2. Druckbare Tintenformulierung nach Anspruch 1, wobei die Formulierung außerdem leitfähige organische oder anorganische Partikelmaterialien umfasst, die aus Kohlenstoffallotrop-Füllstoffen wie Kohlenstoffnanoröhren, Kohlenstoffnanofasern und/oder Rußpartikeln ausgewählt sind und in einer Konzentration zwischen 1-10 Gew.-% des Gesamtgewichts der Tintenformulierung vorhanden sind.

3. Druckbare Tintenformulierung nach einem der vorhergehenden Ansprüche, wobei die Formulierung außerdem leitfähige Polymere umfasst, ausgewählt aus Polyanilin, Poly(3-hexylthiophen-2,5-diyl),Poly(3,4-ethylendioxythiophen) oder anderen inhärent leitfähigen Polymerpartikeln mit bevorzugten Größen zwischen 0,1 und 100 Mikrometern und in einer Konzentration zwischen 1-10 Gew.-% des Gesamtgewichts der Tintenformulierung vorhanden sind.

4. Druckbare Tintenformulierung nach einem der vorhergehenden Ansprüche, wobei das fettsäuremodifizierte Acrylat-Epoxid-Monomer/Oligomer aus Genomer 2312, Genomer 2259, Genomer 3611 ausgewählt wird, das in einer Konzentration zwischen 1,0-8,0 Gew.-% des Gesamtgewichts der Tintenformulierung vorhanden ist.

5. Druckbare Tintenformulierung nach einem der vorhergehenden Ansprüche, wobei die aliphatischen Diacrylat- oder Triacrylatmonomere oder -oligomere aus Sartomer CN132, Sartomer CN133 oder deren Mischung ausgewählt werden und in einer Konzentration zwischen 2,0-25,0 Gew.-% des Gesamtgewichts der Formulierung vorhanden sind.

6. Druckbare Tintenformulierung nach einem der vorhergehenden Ansprüche, wobei das polymerisierbare Verdünnungsmittel aus 1,2-Ethandioldiacrylat, 1,2-Ethandioldimethacrylat, 1,2-Propandioldiacrylat, 1,3-Propandioldiacrylat und den jeweiligen Dimethacrylaten, 1,6-Hexandioldiacrylat oder 1,6-Hexandioldimethacrylat ausgewählt wird und in einem Konzentrationsbereich von 1,0-8,0 Gew.-% des Gesamtgewichts der Tintenformulierung vorhanden ist.

7. Druckbare Tintenformulierung nach einem der vorhergehenden Ansprüche, wobei ein oder mehrere Radikalinitiatoren in einer Konzentration zwischen 0,02- 1,0 % des Gesamtgewichts der Formulierung vorhanden sind.

8. Druckbare Tintenformulierung nach einem der vorhergehenden Ansprüche, wobei ein oder mehrere Radikalinitiatoren aus einem organischen Peroxid, Dicumylperoxid, Bis(1-methyl-1-phenylethyl)peroxid, Dibenzoylperoxid, Dibenzoylperoxid, 1,1-Di(testamylperoxy)cyclohexan, 2,2'-Azobis(2-methylpropionat) ausgewählt werden.

9. Verfahren zur Herstellung der in einem der vorhergehenden Ansprüche beschriebenen druckbaren Tintenformulierung, umfassend die folgenden Schritte:
- Mischen eines Radikalinitiatoren mit einem polymerisierbaren Verdünnungsmittel, gefolgt von der Zugabe einer Mischung aus fettsäuremodifizierten Epoxidacrylat- und/oder -methacrylatmonomeren oder -oligomeren;
- Die vorherige Mischung wird durch Mischen bei einer Temperatur zwischen 20 und 30 °C homogenisiert, um eine Bindemittelkomponente herzustellen;
- Hinzufügen der Mikronanopartikel aus der Alumel-Legierung oder Chromel-Legierung zur Bindemittelkomponente, gefolgt von einer zusätzlichen Homogenisierung durch Mischen, um eine ungehärtete Tintenformulierung zu erzeugen, die die Ni-Legierung enthält.

10. Verfahren nach dem vorhergehenden Anspruch, wobei der Chromel-Legierung oder Alumel-Legierung vor ihrer Beimischung zur Bindemittelkomponente zusätzlich leitfähige organische oder anorganische Partikelmaterialien zugesetzt werden.

11. Verfahren nach einem der Ansprüche 9 bis 10, wobei die Mikronanopartikel aus der Chromel-Legierung 10 bis 120 Minuten lang bei 20-50 °C mit 1-5 M HCl behandelt werden, bevor sie der Bindemittelkomponente hinzugefügt werden.

12. Ein Thermoelement-Sensor, der die in einem der Ansprüche 1 bis 8 beschriebene druckbare Tintenformulierung umfasst.

13. Der Thermoelement-Sensor nach dem vorhergehenden Anspruch, der vom K-Typ ist.

14. Verfahren zur Herstellung eines in den Ansprüchen 12 bis 13 beschriebenen Thermoelement-Sensors, umfassend die folgenden Schritte:
- Drucken eines Thermoelement-Sensors auf ein Substrat unter Verwendung der druckbaren Tintenformulierung, die in einem der Ansprüche 1 bis 8 beschrieben ist;
- Aushärten der druckbaren Tintenformulierung durch schrittweises Erhöhen der Temperatur im Bereich zwischen 50-250 °C, zwischen 20-180 min.

15. Verfahren zur Herstellung eines Thermoelement-Sensors nach dem vorhergehenden Anspruch, wobei das Verfahren ferner einen Schritt der chemischen oder physikalischen Behandlung des ausgehärteten Thermoelement-Sensors umfasst.

16. Eine gedruckte Leiterplatte, die mindestens einen Thermoelement-Sensor nach einem der Ansprüche 12 bis 13 umfasst.

## Revendications

1. Une formulation d'encre imprimable à base d'alliages NiCr et NiAl comprenant la composition suivante :
i) Micro-nanoparticules d'alliage Chromel ou d'alliage Alumel dont les tailles sont comprises entre 0,2 et 12 pm et présentes en une quantité comprise entre 55 et 95 % en poids du poids total de la formulation ;
ii) un mélange de monomères ou d'oligomères d'acrylate et/ou de méthacrylate époxydés modifiés par des acides gras avec des monomères et/ou des oligomères de di- ou triacrylate aliphatiques ;
iii) un ou plusieurs diluants polymérisables ;
iv) un ou plusieurs initiateurs de radicaux libres.

2. Formulation d'encre imprimable selon la revendication 1, dans laquelle la formulation comprend en outre des matériaux particulaires organiques ou inorganiques conducteurs choisis parmi des charges d'allotrope de carbone telles que des nanotubes de carbone, des nanofibres de carbone et/ou des particules de noir de carbone, et présents dans une concentration comprise entre 1 et 10 % en poids du poids total de la formulation d'encre.

3. Formulation d'encre imprimable selon l'une quelconque des revendications précédentes, dans laquelle la formulation comprend en outre des polymères conducteurs choisis parmi la polyaniline, le poly(3-hexylthiophène-2,5-diyle), le poly(3,4-éthylènedioxythiophène) ou d'autres particules de polymère intrinsèquement conductrices avec des tailles préférées entre 0,1 et 100 micromètres pm, et présentes dans une concentration entre 1 et 10 % en poids du poids total de la formulation d'encre.

4. Formulation d'encre imprimable selon l'une quelconque des revendications précédentes, dans laquelle le monomère/oligomère époxy acrylate modifié par un acide gras est choisi parmi le Génomère 2312, le Génomère 2259, le Génomère 3611, étant présents dans une concentration comprise entre 1,0 et 8,0 % en poids du poids total de la formulation d'encre.

5. Formulation d'encre imprimable selon l'une quelconque des revendications précédentes, dans laquelle les monomères ou oligomères de diacrylate ou de triacrylate aliphatique sont choisis parmi Sartomer CN132, Sartomer CN133, ou leur mélange, et sont présents dans une concentration comprise entre 2,0 et 25,0 % en poids du poids total de la formulation.

6. Formulation d'encre imprimable selon l'une quelconque des revendications précédentes, dans laquelle le diluant polymérisable est choisi parmi le diacrylate de 1,2-éthanediol, le diméthacrylate de 1,2-éthanediol, le diacrylate de 1,2-propanediol, le diacrylate de 1,3-propanediol et les diméthacrylates respectifs, le diacrylate de 1,6-hexanediol ou le diméthacrylate de 1,6-hexanediol, et est présent dans une plage de concentration de 1,0 à 8,0 % en poids du poids total de la formulation d'encre.

7. Formulation d'encre imprimable selon l'une quelconque des revendications précédentes, dans laquelle un ou plusieurs initiateurs de radicaux libres sont présents dans une concentration comprise entre 0,02 et 1,0 % du poids total de la formulation.

8. Formulation d'encre imprimable selon l'une quelconque des revendications précédentes, dans laquelle un ou plusieurs initiateurs de radicaux libres sont choisis parmi un peroxyde organique, le peroxyde de dicumyle, le peroxyde de bis(1-méthyl-1-phényléthyle), le peroxyde de dibenzoyle, le peroxyde de dibenzoyle, le 1,1-di(tert-amylperoxy)cyclohexane, le 2,2'-azobis(2-méthylpropionit-rile).

9. Procédé de production de la formulation d'encre imprimable décrite dans l'une quelconque des revendications précédentes, comprenant les étapes suivantes :
- Mélange d'un initiateur de radicaux libres avec un diluant polymérisable, suivi de l'ajout d'un mélange de monomères ou d'oligomères époxy acrylate et/ou méthacrylate modifiés par des acides gras ;
- Le mélange précédent est homogénéisé par malaxage à une température comprise entre 20 et 30°C pour produire un composant liant ;
- Ajout des micro-nanoparticules d'alliage Alumel ou d'alliage Chromel au composant liant, suivi d'une homogénéisation supplémentaire par mélange, pour produire une formulation d'encre non durcie contenant l'alliage Ni.

10. Procédé selon la revendication précédente, dans lequel des matériaux particulaires organiques ou inorganiques conducteurs sont en outre ajoutés à l'alliage Chromel ou à l'alliage Alumel avant leur mélange au composant liant.

11. Procédé selon l'une quelconque des revendications 9 à 10, dans lequel les micro-nanoparticules d'alliage Chromel sont traitées avec du HCl 1-5 M pendant 10 à 120 minutes à 20 et 50°C avant d'être ajoutées au composant liant.

12. Un capteur de thermocouple comprenant la formulation d'encre imprimable décrite dans l'une quelconque des revendications 1 à 8.

13. Le capteur thermocouple selon la revendication précédente qui est du type K.

14. Procédé de fabrication d'un capteur thermocouple selon les revendications 12 à 13, comprenant les étapes suivantes :
- Impression d'un capteur de thermocouple sur un sous-ensemble en utilisant la formulation d'encre imprimable décrite dans l'une quelconque des revendications 1 à 8 ;
- Durcissement de la formulation d'encre imprimable en augmentant progressivement la température dans la plage comprise entre 50 et 250 °C, entre 20 et 180 min.

15. Procédé de fabrication d'un capteur de thermocouple selon la revendication précédente, dans lequel le procédé comprend en outre une étape de traitement chimique ou de traitement physique du capteur de thermocouple durci.

16. Une carte de circuit imprimé comprenant au moins un capteur de thermocouple tel que décrit dans l'une quelconque des revendications 12 à 13.
